# EUROPÄISCHE PATENTANMELDUNG

(11) **EP 1 643 005 A2**
(43) Veröffentlichungstag der Anmeldung: **05.04.2006**
(21) Anmeldenummer: 05405482.0
(22) Anmeldetag: 17.08.2005
(51) Int. Cl.: C23C 16/455, C23C 16/50, C23C 16/511, C23C 16/52

(54) **Abscheiden von organischen und/oder anorganischen Nanoschichten mittels Plasmaentladung**

(30) Priorität: 01.09.2004 CH 14382004
(71) Anmelder: EMPA Eidgenössische Materialprüfungs- und Forschungsanstalt, CH-8600 Dübendorf (CH)
(72) Erfinder: Gröning, Pierangelo, 4573 Lohn-Ammannsegg (CH); Barranco, Angel, 23007 Jaen (ES)
(74) Vertreter: Breiter, Heinz

(57) **Zusammenfassung**

Organische und/oder anorganische Nanoschichten (56) werden mittels Plasmaentladung, insbesondere mittels plasmaunterstützter chemischer Abscheidung aus einer Gas- bzw. Dampfphase, in einem Hochvakuumreaktor (10) auf einem Substrat (16) abgeschieden. Nach dem Evakuieren des Reaktors (10) wird wenigstens eine Komponente der Gruppe bestehend aus wenigstens je einem schichtbildenden Monomer (38), einem Reaktivgas (40) und einem Träger- bzw. Inertgas, in die Anregungszone (26) für das Plasma (24) geleitet. Gleichzeitig werden Farbstoffmoleküle (48) und/oder submikrone Farbstoffpigmente (50) in eine von der Anregungszone (26) für das Plasma räumlich getrennte, ausserhalb der Anregungszone (26) liegende Diffusionszone (52) im Bereich des Substrats (16) geleitet und ohne Agglomerationsbildung in die Nanoschicht (56) eingebaut. Das Verfahren dient insbesondere der Beschichtung von optoelektronischen Bauteilen oder von Textilien.

## Beschreibung

Die Erfindung bezieht sich auf ein Verfahren zum Abscheiden von organischen und/oder anorganischen Nanoschichten auf einem Substrat mittels Plasmaentladung, insbesondere mittels plasmaunterstützter chemischer Abscheidung aus einer Gas- bzw. Dampfphase, in einem Hochvakuumreaktor. Weiter betrifft die Erfindung Anwendungen des Verfahrens.

Bei der Reaktion von Monomeren organischer Kohlenwasserstoffe in einem Plasmareaktor, auch substituierten, entsteht eine Verkettung oder Vernetzung zu Polymeren, sie wird deshalb Plasmapolymerisation genannt. Beispiele von organischen plasmareaktiven Materialien sind Ethylen, Isopropanol, Butylakrylat, Butylen-1, Ethylakrylat, Vinylfluorid, Vinylchlorid, Vinylalkohol, Isobutylmethakrylat, Hydroxyethylakrylat, Acylonitrid, Methylmethakrylat und Styrol. Diese Liste von schichtbildenden Monomeren lässt sich beliebig verlängern.

Die Monomere können mit oder ohne Trägergas in den Reaktor eingeleitet werden. Als Trägergas wird vorzugsweise ein Inertgas eingeleitet, welches auch die Zündung des Plasmas erleichtert und dessen Stabilität erhöht. Dies gilt insbesondere für die Einleitung der Edelgase Argon, Neon und Helium.

Für die Herstellung anorganischer Schichten werden als schichtbildende gasförmige Komponente insbesondere Metallhalogenide, in der Praxis Fluoride und Chloride, Hydride oder metallorganische Komponenten eingesetzt. Beispiele für Metalle sind Aluminium, Titan und Wolfram, sowie die Halbmetalle Bor und Silizium.

Mit Ausnahme einer reinen Plasmapolymerisation wird zusätzlich ein Reaktivgas zugeleitet, beispielsweise Sauerstoff oder Stickstoff, aber auch Kohlenmonoxid, Kohlendioxid, Wasserstoff und/oder Ammoniak. Bei der Zugabe eines Reaktivgases wird von einer plasmaunterstützten chemischen Abscheidung aus einer Gas- bzw. Dampfphase gesprochen, abgekürzt PECVD (Plasma Enhanced Chemical Vapor Deposition).

Insbesondere die abgeschiedenen organischen Schichten haben in der Regel keine oder nur eine blasse Einfärbung, was für viele Anwendungen als Mangel empfunden wird. Es ist bekannt, zusammen mit plasmapolymerisierbaren Monomeren und allenfalls einem Inertgas Farbstoffpartikel in die Reaktionszone einzuleiten, welche der abgeschiedenen Schicht den gewünschten Farbeffekt verleihen. Diese Partikel sind meist anorganisch und lichtundurchlässig, beispielsweise Metallpartikel.

In der Fachzeitschrift "Surface and Coatings Technology 74-75 (1995) 594-597" wird ein Verfahren beschrieben, in welchem anstelle von üblichen Farbstoffpartikeln Farbstoffmoleküle, insbesondere Rhodamin 6G, nach dem thermischen Sublimieren durch ein kleines Loch in der unteren Elektrode in die Reaktionszone geleitet werden. Das Hauptgewicht dieser Publikation liegt bei der Untersuchung optischer Eigenschaften.

Beide in den vorerwähnten Publikationen beschriebenen Verfahren haben den Nachteil, dass der Farbstoff, in Partikel- oder Molekülform, in die Reaktionszone, welche auch Anregungszone genannt wird, geleitet wird. Dadurch können sich wesentliche Änderungen des Farbspektrums ergeben.

Zur Behebung dieses Nachteils wird in einer weiteren wissenschaftlichen Publikation (Pergamon, Band 49, Nr. 3, Seiten 205 bis 211/1998) eine Variante offenbart, nach welcher die Plasmapolymerisation beispielsweise nach 60 Sekunden ausgeschaltet und die Sublimation der Farbstoffmoleküle gestartet wird. Nach 30 Sekunden wird die Plasmapolymerisation während weiteren 60 Sekunden fortgesetzt. Mit diesem Verfahren kann die schädliche Einwirkung des Plasmas auf Farbstoffe vermindert werden, das Verfahren ist jedoch sehr umständlich und aufwendig.

Die Erfinder haben sich die Aufgabe gestellt, ein Verfahren der eingangs genannten Art zu schaffen, welches ein verbessertes Abscheiden von eingefärbten organischen und/oder anorganischen Nanoschichten auf einem Substrat mittels Plasmaentladung erlaubt. Die Farbstoffe sollen in keiner Weise beeinträchtigt werden, und überdies soll ein einfaches und kostengünstiges Verfahren durchgeführt werden können. Weiter soll ein breites Spektrum von Anwendungen des Verfahrens eröffnet werden.

In Bezug auf das Verfahren wird die Aufgabe erfindungsgemäss dadurch gelöst, dass nach dem Evakuieren des Reaktors wenigstens eine Komponente der Gruppe bestehend aus wenigstens je einem schichtbildenden Monomer, einem Reaktivgas und einem Träger- bzw. Inertgas, in die Anregungszone für das Plasma sowie gleichzeitig Farbstoffmoleküle und/oder submikrone Farbstoffpigmente in eine von der Anregungszone für das Plasma räumlich getrennte, ausserhalb der Anregungszone liegende Diffusionszone im Bereich des Substrats geleitet und ohne Agglomerationsbildung in die Nanoschicht eingebaut werden. Weiterbildende und vorteilhafte Ausführungsformen des Verfahrens sind Gegenstand von abhängigen Ansprüchen.

Bei der Plasmapolymerisation von organischen Monomeren kann sich die Zuleitung eines Reaktivgases erübrigen, wenn es sich um eine reine Verkettung oder Vernetzung von Molekülketten handelt, d. h. ohne dass gleichzeitig eine chemische Reaktion stattfindet. Zur Erzeugung von anorganischen Nanoschichten ist stets ein Reaktivgas notwendig. Ein Träger- bzw. Inertgas, insbesondere ein Edelgas kann allein in die Anregungszone eingeleitet werden, wobei mit polymerisierbaren Farbstoffmolekülen Nanoschichten mit hervorragenden optischen Eigenschaften erzielt werden.

Vor dem Reaktionsbeginn wird vorzugsweise ein Inertgas in den evakuierten Reaktor eingeleitet, welches als Trägergas für die Zündung fungiert und die Stabilität des Plasmas erhöht. Als Inertgase eignen sich wie bekannt in erster Linie Edelgase, insbesondere Argon, Neon und/oder Helium.

Wie erwähnt werden als schichtbildende Monomere in erster Linie Kohlenwasserstoffe, auch substituierte, und Silane eingesetzt, wobei die Silane auch anorganische Schichten bilden können, insbesondere Siliziumdioxid, SiO₂. Der Ausdruck "schichtbildende Monomere" wird hier auch für metallhaltige Komponenten, insbesondere Metallhalogenide und Metallhydride, metallorganische Verbindungen, verwendet, welche mit Hilfe von Reaktivgasen anorganische Schichten bilden. In diesem Fall spricht man von PECVD-Reaktionen, plasmaunterstützten chemischen Abscheidungen aus der Gas- oder Dampfphase. Die gängigsten als schichtbildende Monomere eingesetzten Metallverbindungen sind in der Beschreibungseinleitung erwähnt.

Das Spektrum von einsetzbaren Farbstoffmolekülen ist gross, dank der in der Diffusionszone niedrigen Temperatur, vorzugsweise Raumtemperatur, bleiben die Eigenschaften der Farbstoffmoleküle unverändert. Beispielsweise wird Rhodamin 6G, Auramin O, Erytrosin B, Methylenblau, Metanilgelb, Kongorot und/oder Nileblau A in die Diffusionszone geleitet. Die Farbstoffmoleküle können durch Sublimation von aussen über eine Gasleitung oder im Reaktor aus einem Verdampfer dem Abscheidungsprozess in der Diffusionszone zugefügt werden. Die Farbstoffmoleküle sind homogen in der Nanoschicht verteilt.

Ebenfalls dank der tiefen Abscheidungstemperatur können der Diffusionszone alternativ oder zusätzlich zu den Farbstoffmolekülen submikrone Farbstoffpigmente zugeführt und zusammen mit den schichtbildenden Monomeren zur Bildung der Nanoschicht abgeschieden werden. Auch die Farbstoffpigmente sind homogen verteilt, es werden keine Agglomerationen gebildet. Wie bei den Farbstoffmolekülen sind praktisch alle bekannten Farbstoffpigmente geeignet, beispielsweise Oxide, Sulfate, Silikate und Chromate, insbesondere von Zinn, Blei, Zink, Titan, Barium, Kalzium und/oder Magnesium. Der grösste Korndurchmesser der Farbstoffpigmente sollte wesentlich unterhalb der Dicke der abgeschiedenen Nanoschicht liegen, vorzugsweise unterhalb 50 %. Die Farbstoffpigmente werden in einem inerten Trägergas in die Diffusionszone geleitet.

Durch gleichzeitiges oder aufeinanderfolgendes Einleiten von Farbstoffmolekülen und/oder Farbstoffpigmenten in die Diffusionszone des Reaktors können alle gängigen Mischfarben erzielt werden. Weiter kann über den Fluss der schichtbildenden Monomere, der allenfalls zugeführten Reaktivgase, der Farbstoffmoleküle und/oder Farbstoffpigmente die Struktur und die Farbintensität der abgeschiedenen Nanoschicht in an sich bekannter Weise gesteuert werden.

Nach einer besonderen Ausführungsform der Erfindung können wenigstens teilweise fluoreszierende Farbstoffmoleküle und/oder Farbstoffpigmente in die Diffusionszone des Reaktors eingeleitet werden.

Alle in der Plasmatechnologie mit einer bei Raumtemperatur liegenden Diffusionszone eingesetzten Substrate eignen sich auch zur Durchführung der vorliegenden Erfindung. Dies gilt sowohl bezüglich der Form als auch des Materials. Das Substrat kann als Platte oder Formkörper auf einem Substrathalter fest montiert oder als endlos durchlaufendes Organ in Form eines Bandes, einer Schnur, eines Fadens oder dgl. ausgebildet sein. Es eignen sich alle üblichen Substratmaterialien, beispielsweise polymere Kunststoffe, Textilien, keramische Werkstoffe, Glas, verschiedene Metalle, insbesondere Stahl, Aluminium, Kupfer und Messing, und Halbleiter, insbesondere Silizium, III - V Halbleiter, wie z. B. GaAs, und II - VI Halbleiter, wie z. B. ZnS.

Zur Durchführung des Verfahrens eignen sich alle in der Plasmatechnologie eingesetzten Hochvakuumreaktoren, bei welchen die Anregungs- oder Reaktionszone einerseits und die Diffusionszone mit dem Substrat andrerseits räumlich klar getrennt sind. Bezüglich der übrigen Bauweise, den Baumaterialien, der Energieversorgung, der Zufuhr von Ausgangsstoffen, den Mess- und Analyseeinrichtungen weist der zur Durchführung des erfindungsgemässen Verfahrens eingesetzte Hochvakuumreaktor keine grundsätzlichen Unterschiede auf.

Der vorliegende Reaktortyp wird auch "Remote-Anlage" genannt. Bevorzugt sind elektrodenlose Reaktoren, insbesondere zur Erzeugung eines induzierten Radiowellen (RF)- oder eines Mikrowellenplasmas. Die Wellenlänge λ von Mikrowellen liegt im Bereich von 10⁻² bis 1 m, von Radiowellen im Bereich von 1 bis 10⁴m.

Das Abscheiden mittels eines Mikrowellenplasmas erfolgt vorzugsweise mit einer Leistung von 10 bis 1000 Watt, insbesondere von 50 bis 200 Watt.

Mit dem eingesetzten Reaktor kann ein Vakuum von wenigstens 10⁻⁶ mbar erzeugt werden, weshalb dieser als Hochvakuumreaktor bezeichnet wird. Vor dem Beginn des Abscheidungsprozesses wird der Reaktor auf etwa 10⁻⁶ mbar evakuiert. Während der Abscheidung wird ein Arbeitsdruck im Bereich von 10⁻² bis 10 mbar aufrechterhalten.

Der Abscheidungsprozess bis zum Erreichen einer vorgegebenen Enddicke der Nanoschicht im Bereich von vorzugsweise 10 bis 200 nm, insbesondere 20 bis 100 nm, erreicht wird, dauert in der Regel höchstens einige Minuten, insbesondere eine Minute oder weniger.

Die Anwendungsmöglichkeiten des erfindungsgemässen Verfahrens sind ausserordentlich vielgestaltig, sie liegen schwergewichtig im Bereich der Beschichtung von mikroelektronischen Bauteilen und der Beschichtung von Textilien oder als Schicht für optoelektronische Anwendungen.

Spezielle Anwendungen des Verfahrens sind beispielsweise die Herstellung von Wellenleitern für Lasermatrizen, optischen Gassensoren, Strahlungsdetektoren, elektrolumineszierende Einrichtungen, Leuchtdioden und Messvorrichtungen für die Radioaktivität.

Zusammenfassend wird nochmals festgehalten, dass mit dem erfindungsgemässen Verfahren Nanoschichten hergestellt werden können, in welche Farbstoffmoleküle und/oder Farbstoffpigmente ohne Änderung ihres Farbspektrums eingebaut werden können. Dies erfolgt in einfacher und wirtschaftlicher Weise.

### Beispiel 1

Ein Hochvakuumreaktor wird auf einen Druck von 10⁻⁶ mbar evakuiert. Nach dem Erreichen und Aufrechterhalten dieses Basisdrucks während einigen Minuten wird als Trägergas Argon mit einem Gasfluss von 3 sccm zugeführt. Nach dem Zünden des Plasmas wird als schichtbildendes Monomer Si(CH₃)₄ mit einem Gasfluss von 1 sccm und als Reaktivgas O₂ mit einem Gasfluss von ebenfalls 1 sccm zugeführt. Der Arbeitsdruck wird dabei auf 2 x 10⁻² mbar erhöht. Die Mikrowellenleistung des elektrodenlosen Hochvakuumreaktors beträgt 100 Watt. In die räumlich vom Plasma getrennte Diffusionszone des Reaktors werden Farbstoffmoleküle aus Rhodamin 6G eingeleitet und zusammen mit dem schichtbildenden Monomer zu einer etwa 50 nm zu einer rotgefärbten SiO₂ Schicht abgeschieden.

### Beispiel 2

In einen auf einen Basisdruck von 10⁻⁶ nm evakuierten und mit Argon gefluteten Reaktor wird in der Anregungszone ein Plasma gebildet. Als schichtbildendes Monomer wird Isopropanol mit einem Gasfluss von 1 sccm eingeleitet, ein Reaktivgas ist nicht notwendig. Bei einem Arbeitsdruck von 10⁻² mbar und einer Mikrowellenleistung von 100 Watt wird in der Diffusionszone wiederum Rhodamin 6G in Molekülform zugeleitet. Auf dem Substrat wird nach 30 Sekunden eine etwa 25 nm dicke rotgefärbte Kunststoffschicht gebildet.

Die Erfindung wird anhand von in der Zeichnung dargestellten Ausführungsbeispielen, welche auch Gegenstand von abhängigen Ansprüchen sind, näher erläutert. Es zeigen schematisch:
- Fig. 1 einen Hochvakuumreaktor,
- Fig. 2 einen Querschnitt durch ein beschichtetes Substrat,
- Fig. 3 einen Radialschnitt III-III gemäss Fig. 1, und
- Fig. 4 einen Vertikalschnitt IV-IV gemäss Fig. 2

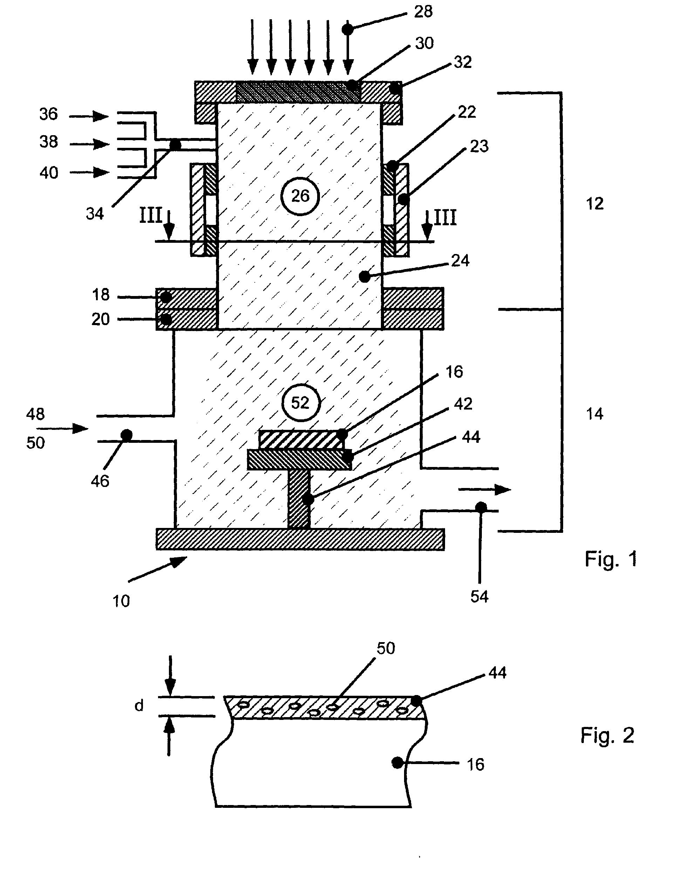

Ein in Fig. 1 dargestellter Hochvakuumreaktor 10 ist im wesentlichen zylinderförmig ausgebildet und umfasst einen im Querschnitt kleineren oberen Teil 12 mit einer Plasmaquelle und einen unteren Teil 14 mit einem Substrat 16, vorliegend eine Glasplatte. Die beiden Teile 12, 14 des Hochvakuumreaktors 10 sind über Flansche 18, 20 vakuumdicht miteinander verschraubt. Der Hochvakuumreaktor 10 besteht im wesentlichen aus rostfreiem Stahl und weist den Anforderungen entsprechende grosse Wanddicken auf. Um den Aussenmantel des oberen Teils 12 ist ein Ring 22 von FeNdB (= Eisen, Neodyn, Bor)- Permanentmagneten zur Erzeugung eines magnetischen Feldes für die Plasmaanregung gelegt. Ein Weichstahljoch 23 verbindet die zwei Magnetringe 22, damit wird ein bestmöglicher magnetischer Fluss erzielt. Ein gezündetes Plasma 24, vorliegend ein ECR-Plasma (ECR = Electron Cyclotron Resonance), füllt den oberen Teil 12 des Hochvakuumreaktors 10, wobei im Inneren des Rings 22 eine Anregungs- oder Reaktionszone 26 gebildet wird.

In axialer Richtung des Hochvakuumreaktors 10 werden von oben durch Pfeile charakterisierte Mikrowellen 28 einer Frequenz f von vorliegend 2.45 GHz über ein Fenster 30 im Reaktordeckel 32 in den Innenraum des oberen Teils 12 geleitet.

Oberhalb des Rings 22 ist ein axial in den Innenraum des oberen Teils 12 mündender Rohrstutzen 34 ausgebildet, welcher seinerseits je einen Einlass für Inertgas bzw. Trägergas 36, schichtbildende Monomere 38 und Reaktivgas 40 aufweist. Trägergas 36 und schichtbildende Monomere 38 können auch bereits vorher gemischt werden. Der Einlass für Reaktivgas 40 wird geschlossen, wenn kein solches notwendig ist. Alternativ können drei direkt in den Innenraum des oberen Teils 12 führende Rohrstutzen 34 ausgebildet sein.

Der untere Teil 14 des Hochvakuumreaktors 10 umfasst einen Substrathalter 42 mit dem Substrat 16, wobei ein höhenverstellbarer Substratträger 44 vorgesehen ist. Über einen Rohrstutzen 46 werden externe Farbstoffmoleküle 48, nach einer Variante Farbstoffpigmente 50, in eine Diffusionszone 52 des unteren Teils 14 geführt, wo Raumtemperatur herrscht. In der Regel wird für die Zufuhr von Farbstoffmolekülen 48 bzw. Farbstoffpigmenten 50 ebenfalls ein Träger-, bzw. Inertgas 36 verwendet.

Über einen weiteren Rohrstutzen 54 wird von einer nicht dargestellten Vakuumpumpe die gasförmige Phase abgesaugt. Die schichtbildenden Monomere 38 bzw. deren Reaktionsprodukte aus der Anregungs- oder Reaktionszone 26 werden zusammen mit den Farbstoffmolekülen 48 und/oder Fabstoffpigmenten 50 als gefärbte Nanoschicht 56 abgeschieden.

Eine abgeschiedene Nanoschicht 56 einer Dicke d von 50 nm ist in Fig. 2 bezüglich des Substrats 16 stark überhöht dargestellt. Weiter sind der Anschaulichkeit wegen alle von der Schnittebene erfassten Farbstoffpigmente 50 gleich gross gezeichnet. Farbstoffmoleküle 48 sind in äquivalenter Weise in die Nanoschicht 56 von 50 nm Dicke eingebaut.

Der Teil 12, gemäss Fig. 1 die ECR-Plasmaquelle, kann je nach Anregungsart des Plasmas 24 in der Anregungszone 26 unterschiedlich ausgebildet sein, z. B. als Mikrowellen-Plasmaquelle ohne Magnete oder als induktiv gekoppelte RF-Plasmaquelle.

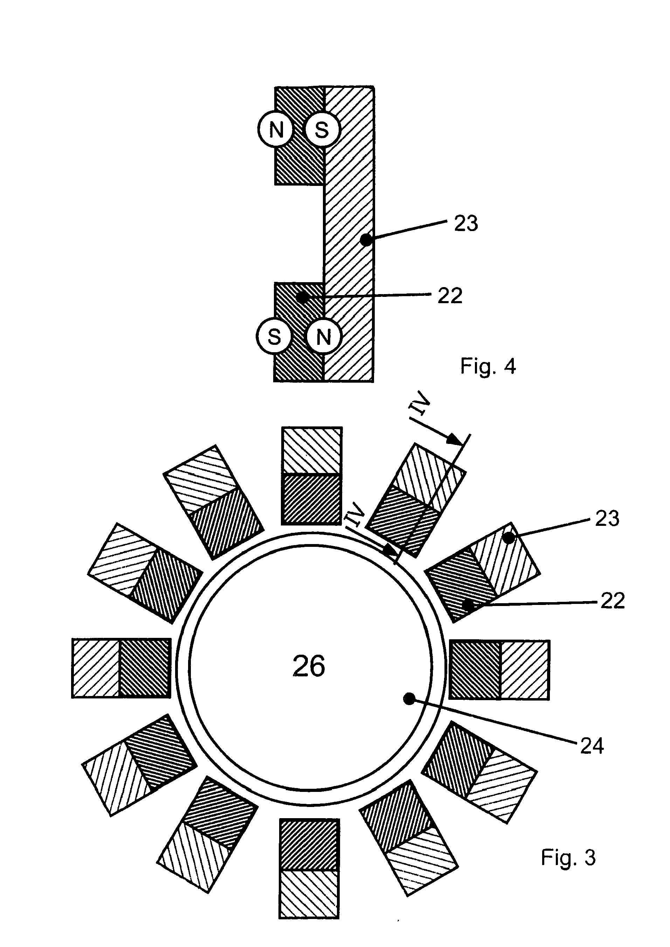

Nach der Ausführungsform von Fig. 3 und 4 bilden die Magnete 22 und die Weichstahljoche 23 zwölf peripher um den Umfang des oberen Teils 12 des Reaktors 10 angeordnete Magnetschuhe, je regelmässiger angeordnet, desto besser. Alle Magnetschuhe weisen in der Anordnung gemäss Fig. 3 dieselbe Orientierung auf, so dass sich ein im Inneren torodiales inhomogenes Magnetfeld aufbaut. Die magnetische Feldstärke der Permanentmagnete muss so gewählt werden, dass das inhomogene Magnetfeld im Inneren an einigen Stellen eine Feldstärke aufweist, die für die ECR Bedingung erforderlich ist. Für eine Mikrowellenfrequenz von 2.45 GHz sind dies 875 MilliTesla (mT). Für andere Mikrowellenfrequenzen ergeben sich entsprechend andere Feldstärken.

In Fig. 4 ist die Anordnung der magnetischen Nord- N und Südpole S der Magnete 22 dargestellt.

## Patentansprüche

1. Verfahren zum Abscheiden von organischen und/oder anorganischen Nanoschichten (56) auf einem Substrat (16) mittels Plasmaentladung, insbesondere mittels plasmaunterstützter chemischer Abscheidung aus einer Gas- bzw. Dampfphase, in einem Hochvakuumreaktor (10),
**dadurch gekennzeichnet, dass**
nach dem Evakuieren des Reaktors (10) wenigstens eine Komponente der Gruppe bestehend aus wenigstens je einem schichtbildenden Monomer (38), einem Reaktivgas (40) und einem Träger- bzw. Inertgas, in die Anregungszone (26) für das Plasma (24) sowie gleichzeitig Farbstoffmoleküle (48) und/oder submikrone Farbstoffpigmente (50) in eine von der Anregungszone (26) für das Plasma räumlich getrennte, ausserhalb der Anregungszone (26) liegende Diffusionszone (52) im Bereich des Substrats (16) geleitet und ohne Agglomerationsbildung in die Nanoschicht (56) eingebaut werden.

2. Verfahren nach Anspruch 1, **dadurch gekennzeichnet, dass** als Träger- bzw. Inertgas (36) ein Edelgas in die Anregungszone (26) für das Plasma (24) geleitet wird, vorzugsweise schon vor der Einleitung der schichtbildenden Monomeren (38).

3. Verfahren nach Anspruch 1 oder 2, **dadurch gekennzeichnet, dass** als
- schichtbildende Monomere (38) Kohlenwasserstoff oder Silane, auch substituierte Komponenten, für organische Nanoschichten (56) oder Metallhalogenide, Metallhydride oder metallorganische Verbindungen für anorganische Nanoschichten (56), und/oder
- Reaktivgase (40) Sauerstoff, Stickstoff, Kohlenmonoxid, Kohlendioxid, Wasserstoff und/oder Ammoniak, und/oder
- Inertgase Argon, Neon und/oder Helium in die Anregungszone (26) für das Plasma (24) geleitet werden.

4. Verfahren nach einem der Ansprüche 1 bis 3, **dadurch gekennzeichnet, dass** wenigstens eines der Farbstoffmoleküle Rhodium 6G, Auramin O, Erythrosin B, Methylenblau, Metanilgelb, Kongorot, und/oder Nileblau A in die Diffusionszone (52) geleitet wird.

5. Verfahren nach einem der Ansprüche 1 bis 4, **dadurch gekennzeichnet, dass** wenigstens eines der Farbstoffpigmente (50) bestehend aus Oxiden, Sulfaten, Silikaten und Chromaten, insbesondere von Zinn, Blei, Zink, Titan, Barium, Kalzium und/oder Magnesium in die Diffusionszone (52) geleitet werden, wobei der grösste Korndurchmesser der Farbstoffpigmente 50 unterhalb 50 % der Dicke (d) der Nanoschicht (56) liegt.

6. Verfahren nach einem der Ansprüche 1 bis 5, **dadurch gekennzeichnet, dass** zur Erzeugung von Mischfarben verschiedene Farbstoffmoleküle (48) und/oder Farbstoffpigmente (50) gleichzeitig oder nacheinander in die Diffusionszone (52) geleitet werden.

7. Verfahren nach einem der Ansprüche 1 bis 6, **dadurch gekennzeichnet, dass** fluoreszierende Farbstoffmoleküle (48) und/oder Farbstoffpigmente (50) eingeleitet werden.

8. Verfahre nach einem der Ansprüche 1 bis 7, **dadurch gekennzeichnet, dass** ein elektrodenloser, vorzugsweise ein induziertes Radiowellen- oder Mikrowellenplasma (24) erzeugt wird.

9. Verfahren nach einem der Ansprüche 1 bis 8, **dadurch gekennzeichnet, dass** ein Mikrowellenplasma (24) einer Leistung von 10 bis 1000 Watt, vorzugsweise 50 bis 200 Watt, erzeugt wird.

10. Verfahren nach einem der Ansprüche 1 bis 9, **dadurch gekennzeichnet, dass** der Reaktor vor dem Einleiten von Gasen auf einen Basisdruck von etwa 10⁻⁶ mbar evakuiert und während der Abscheidung ein Arbeitsdruck von 10⁻² bis 10 mbar aufrechterhalten wird.

11. Verfahren nach einem der Ansprüche 1 bis 10, **dadurch gekennzeichnet, dass** die Nanoschichten (56) bei Raumtemperatur auf dem Substrat (16) abgeschieden werden.

12. Verfahren nach einem der Ansprüche 1 bis 11, **dadurch gekennzeichnet, dass** Nanoschichten (56) einer Schichtdicke (d) von 10 bis 200 nm, vorzugsweise 20 bis 100 nm, auf dem Substrat (16) abgeschieden werden.

13. Anwendung des Verfahrens nach einem der Ansprüche 1 bis 12 zur Beschichtung von optoelektronischen Bauteilen oder von Textilien.

14. Anwendung des Verfahrens nach Anspruch 13 zur Herstellung von Wellenleitern für Lasermatrizen, optischen Gassensoren, Strahlendetektoren, elektrolumineszierenden Einrichtungen, Leuchtdioden und Messeinrichtungen für die Radioaktivität.
